(19) Europäisches Patentamt / European Patent Office / Office européen des brevets

(11) EP 4 660 266 A1

(12) **EUROPEAN PATENT APPLICATION**
published in accordance with Art. 153(4) EPC

(43) Date of publication:
**10.12.2025 Bulletin 2025/50**

(21) Application number: **24750011.9**

(22) Date of filing: **22.01.2024**

(51) International Patent Classification (IPC):
***C09J 4/02*** *(2006.01)* ***C08F 220/10*** *(2006.01)*
***C08F 220/26*** *(2006.01)* ***H01L 21/02*** *(2006.01)*

(52) Cooperative Patent Classification (CPC):
**C08F 220/10; C08F 220/26; C09J 4/00; H01L 21/02**

(86) International application number:
**PCT/JP2024/001583**

(87) International publication number:
**WO 2024/162058 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.01.2023 JP 2023013524**

(71) Applicant: **Denka Company Limited**
**Tokyo 103-8338 (JP)**

(72) Inventors:
- **TAKAHASHI, Yusuke**
  **Tokyo 103-8338 (JP)**
- **TANIGAWA HOSHINO, Takako**
  **Tokyo 103-8338 (JP)**
- **YAMAMOTO, Shota**
  **Tokyo 103-8338 (JP)**
- **KURIMURA, Hiroyuki**
  **Tokyo 103-8338 (JP)**

(74) Representative: **Hoffmann Eitle**
**Patent- und Rechtsanwälte PartmbB**
**Arabellastraße 30**
**81925 München (DE)**

# (54) COMPOSITION FOR TEMPORARY FIXING, ADHESIVE FOR TEMPORARY FIXING, AND THIN WAFER PRODUCTION METHOD

(57) The present invention provides a composition for temporary bonding including: (A) a polymerizable component including a (meth)acrylate containing an aromatic ring bonded to a heteroatom; (B) a photo radical polymerization initiator; and (C) an ultraviolet absorber having a polymerizable functional group, in which an equivalent amount of the aromatic ring bonded to the heteroatom in 1 g of the composition for temporary bonding is 0.50 mmol or more and 3 mmol or less.

EP 4 660 266 A1

## Description

### Technical Field

The present invention relates to a composition for temporary bonding, an adhesive for temporary bonding, and a method for producing a thin wafer.

### Background Art

In the production of electronic devices, an inorganic material represented by silicon is used as a substrate, and a wafer substrate having a thickness of about a few hundred micrometers produced by forming an insulation film and a circuit on the surface of the substrate, and subjecting the resultant substrate to processing such as thinning by grinding is frequently used. However, since most of the materials of the substrate are fragile and easily broken, measures to prevent breaking need to be taken particularly for thinning by grinding. A method has been taken as such measures, in which a protective tape for temporary bonding, which can be peeled after the completion of the step of processing, is applied to the surface opposite to the surface to be ground (also referred to as a back surface). As this tape, an organic resin film is used for a base material. Although the tape is flexible, their strength and heat resistance are insufficient, and thus the tape is not suitable for use in steps at high temperature.

Then, a system has been proposed, which provides durability sufficient for conditions in a step of backgrinding and forming an electrode on the back surface by bonding the substrate of an electronic device to a support member such as silicon or glass with an adhesive interposed therebetween. What is important in the system is the adhesive layer for bonding the substrate to the support member. The adhesive layer needs to be capable of bonding the substrate to the support member without any gap, and have durability sufficient for withstanding the subsequent steps, and needs to enable the thinned wafer to be easily peeled from the support member in the final step, i.e. temporarily fixed.

In the processing of such a wafer, a spin coating step, a vacuum bonding and photo-curing step, a thinning processing step by grinding and polishing, a high temperature processing step, a laser peeling step, and a removing step of an agent for temporary bonding are mainly performed.

In the spin coating step, in order to uniformly form a film of the agent for temporary bonding on the wafer, there is a need for the agent for temporary bonding to have a suitable viscosity and to be a Newtonian fluid (or to have shear rate independency of shear viscosity).

In the vacuum bonding/UV curing step, the agent for temporary bonding needs to be capable of being cured on a support member such as glass by irradiation with light such as ultraviolet rays (UV) in a short time, and to generate less outgas (low outgassing properties).

In the thinning processing step by grinding and polishing, in order to avoid breaking due to a locally applied load of a grinding machine to the substrate, the agent for temporary bonding needs to have appropriate hardness capable of preventing local sinking of the substrate and maintaining flatness while dispersing the load in the in-plane direction. In addition, adhesiveness with the support member, an appropriate height of an elastic modulus for protecting an edge, and chemical resistance are also needed.

In the high temperature processing step, the agent for temporary bonding needs to have heat resistance capable of withstanding high temperature processing in vacuum for a long time (e.g. at 300°C or higher for one hour or longer).

In the laser peeling step, the agent for temporary bonding needs to be peeled at high speed by a laser such as a UV laser.

In the removal step, in addition to easy peeling properties that can cause the substrate to be easily peeled from the support member, cohesion characteristics and easy washability for not leaving residues of the adhesive on the substrate after peeling are required.

In view of such a background, for example, Patent Literature 1 discloses a composition for temporary bonding containing: (A-1) a monofunctional (meth)acrylate whose side chain is an alkyl group having 18 or more carbons and homopolymer has a Tg of -100°C to 60°C; (A-2) a polyfunctional (meth)acrylate; (B) a polyisobutene homopolymer and/or a polyisobutene copolymer; and (C) a photo radical polymerization initiator, and it is said that the composition is excellent in heat resistance, low outgassing properties, and peeling properties.

### Citation List

### Patent Literature

Patent Literature 1: WO 2021/235406 A

### Summary of Invention

Technical Problem

When peeling an agent for temporary bonding (i.e. an adhesive layer) cured on a wafer, a laser is emitted through a transparent support member such as glass while the laser is swept over, and thus the adhesive layer at the irradiated portion is decomposed to form a hole (a recess covered with a support member). The gas vaporized in the hole expands at a high temperature, as a result of which the support member is pushed up and likely to be peeled.

In the meantime, radiant energy is absorbed by laser irradiation, and thus the irradiated portion generates heat and the temperature rises. Accordingly, as the output of laser irradiation is higher, the cured agent for temporary bonding is more likely to be decomposed, but the temperature of the substrate adjacent to the agent for temporary bonding also increases, which is not preferred from the viewpoint of ensuring the quality of the substrate.

The present invention has been completed in view of the above problems. In an embodiment, an object of the present invention is to provide a composition for temporary bonding exhibiting an excellent peeling property upon low power laser irradiation. In another embodiment, an object of the present invention is to provide an adhesive for temporary bonding containing such a composition for temporary bonding, and a method for producing a thin wafer using the adhesive for temporary bonding.

Solution to Problem

As a result of diligent research, the present inventors have found that the above problems can be solved by controlling an equivalent amount of an aromatic ring bonded to a heteroatom in a composition for temporary bonding. Details of the reason will be described later, and it is presumed that the aromatic ring bonded to the heteroatom is likely to absorb a laser having a specific wavelength, and the adhesive layer can be decomposed by low energy. The present invention has been completed based on the above findings, and is exemplified below.

[1] A composition for temporary bonding including the following (A) to (C):

(A) a polymerizable component including a (meth)acrylate containing an aromatic ring bonded to a heteroatom;
(B) a photo radical polymerization initiator; and
(C) an ultraviolet absorber having a polymerizable functional group,

wherein an equivalent amount of the aromatic ring bonded to the heteroatom in 1 g of the composition for temporary bonding is 0.50 mmol or more and 3 mmol or less.

[2] The composition for temporary bonding according to [1], wherein the component (A) includes one or more selected from the group consisting of 9,9-bis[4-(2-hydroxy $C_1$ to $C_{20}$ alkoxy)phenyl]fluorene di(meth)acrylate, $C_1$ to $C_{20}$ alkoxylated bisphenol A di(meth)acrylate, 1,3-bis(2-(meth)acryloyloxy $C_1$ to $C_{20}$ alkyl)benzene, 2,2-bis(4-(meth)acryloxydiethoxyphenyl)propane, and structural isomers thereof.

[3] The composition for temporary bonding according to [1], wherein the component (A) contains one or more selected from the group consisting of nonylphenoxypolyethylene glycol (meth)acrylate, phenoxyethyl (meth)acrylate, and structural isomers thereof.

[4] The composition for temporary bonding according to any one of [1] to [3], wherein the component (B) is one or more selected from bis(2,4,6-trimethylbenzoyl)phenylphosphine oxide and 1-[9-ethyl-6-(2-methylbenzoyl)-9H-carbazole-3-yl]ethanone 1-(O-acetyloxime).

[5] The composition for temporary bonding according to any one of [1] to [4], wherein the component (C) has one or more selected from the group consisting of a benzophenone skeleton, a triazole skeleton, a hydroxyphenyl triazine skeleton, and a phenol skeleton, and has a polymerizable functional group.

[6] The composition for temporary bonding according to any one of [1] to [5], wherein a content of the component (B) is from 0.01 to 5 parts by mass and a content of the component (C) is from 0.005 to 15 parts by mass, relative to a total of 100 parts by mass of the component (A).

[7] An adhesive for temporary bonding including the composition for temporary bonding according to any one of [1] to [6].

[8] A method for producing a thin wafer using the adhesive for temporary bonding according to [7], the method including the steps of:

bonding a base material of a thin wafer to an optically transparent support member with the adhesive for temporary bonding interposed therebetween;
photo-curing the adhesive for temporary bonding from a side of the support member to form an adhesive layer and causing the base material to adhere to the support member;

processing the base material to form a thin wafer; and
emitting light having a wavelength of 350 nm to 385 nm from the side of the support member to decompose the adhesive layer, and peeling the thin wafer from the support member.

[9] A composition including the following (A) to (C) :

(A) a polymerizable component including a (meth)acrylate containing an aromatic ring bonded to a heteroatom;
(B) a polymerization initiator; and
(C) an ultraviolet absorber having a polymerizable functional group,

wherein an equivalent amount of the aromatic ring bonded to the heteroatom in 1 g of the composition is 0.50 mmol or more and 3 mmol or less.

Advantageous Effects of Invention

According to an embodiment of the present invention, it is possible to provide a composition for temporary bonding exhibiting an excellent peeling property upon low power laser irradiation. In addition, in another embodiment of the present invention, it is possible to provide an adhesive for temporary bonding containing such a composition for temporary bonding, and a method for producing a thin wafer using the adhesive for temporary bonding.

Description of Embodiments

Next, embodiments of the present invention will be described in detail. It should be understood that the present invention is not limited to the following embodiments, and that design changes, improvements, and the like are appropriately made based on ordinary knowledge of those skilled in the art without departing from the spirit of the present invention.

Unless otherwise stated herein, numerical ranges are intended to include upper and lower limit values of the numerical ranges. The (meth)acrylate used herein refers to a compound having one or more (meth)acryloyl groups in one molecule. The monofunctional (meth)acrylate refers to a compound having one (meth)acryloyl group in one molecule. The polyfunctional (meth)acrylate refers to a compound having two or more (meth)acryloyl groups in one molecule. The n-functional (meth)acrylate refers to a compound having n numbers of (meth)acryloyl groups in one molecule. The polymerizable functional group in the polyfunctional (meth)acrylate may have only an acryloyl group, may have only a methacryloyl group, or may have both an acryloyl group and a methacryloyl group. Notations such as "$C_1$ to $C_{20}$" or "$C_{10}$ to $C_{20}$" mean a hydrocarbon group having from 1 to 20 carbons or a hydrocarbon group having from 10 to 20 carbons.

In an embodiment, the present invention provides a composition for temporary bonding containing the following (A) to (C):

(A) a polymerizable component including a (meth)acrylate containing an aromatic ring bonded to a heteroatom;
(B) a photo radical polymerization initiator; and
(C) an ultraviolet absorber having a polymerizable functional group.

Here, the equivalent amount of the aromatic ring bonded to the heteroatom in 1 g of the composition for temporary bonding is 0.5 mmol or more and 3.0 mmol or less.

(1. Component (A))

The polymerizable component: the component (A) contained in the composition for temporary bonding of the present embodiment plays a role of forming a (meth)acrylic polymerization skeleton. The composition for temporary bonding of the present embodiment may contain a non-polymerizable component, and the amount of the non-polymerizable component is preferably less than 15 parts by mass relative to a total of 100 parts by mass of the non-polymerizable component and the component (A). The "non-polymerizable component" used herein is defined as a component other than the component (B), i.e. a component that is not used in the art as a photo radical polymerization initiator.

The polymerizable component: the component (A) contained in the composition for temporary bonding of the present embodiment contains a (meth)acryloyl group and plays a role of forming a (meth)acrylic polymerization skeleton. The polymerizable component is preferably a polymerizable organic compound component. The component (A) may preferably contain a compound having two or more (meth)acryloyl groups. The component (A) may be a monofunctional (meth)acrylate, a bifunctional (meth)acrylate, a tri- or higher functional polyfunctional (meth)acrylate, or a mixture thereof. Preferably, the component (A) may include a combination of a polyfunctional (meth)acrylate and a monofunctional (meth)acrylate (more preferably, a combination of a bifunctional (meth)acrylate and a monofunctional (meth)acrylate).

Examples of the polyfunctional (meth)acrylate that may be contained in the component (A) include an aromatic bifunctional (meth)acrylate, an alicyclic bifunctional (meth)acrylate, or a mixture thereof from the viewpoint of enabling provision of a rigid structure. The component (A) may include an acyclic polyfunctional (meth)acrylate. The polyfunctional (meth)acrylate may be a monomer, a polymer, or a mixture thereof. That is, the polymerizable polymer described above may be a polymer of the polyfunctional (meth)acrylate.

The molecular weight of the polyfunctional (meth)acrylate monomer is preferably 900 or less, more preferably 700 or less, still more preferably 500 or less, and yet still more preferably 400 or less.

The weight-average molecular weight of the polyfunctional (meth)acrylate polymer is preferably from 5000 to 200000. The weight-average molecular weight of the polyfunctional (meth)acrylate polymer is 5000 or more, and thus an appropriate viscosity may be obtained when the polyfunctional (meth)acrylate polymer is blended with another polymerizable component. The weight-average molecular weight of the polyfunctional (meth)acrylate polymer is 10000 or more, and thus an appropriate thickening effect may be obtained. From this viewpoint, the weight-average molecular weight of the polyfunctional (meth)acrylate polymer is more preferably 6000 or more, still more preferably 7000 or more. The weight-average molecular weight of the polyfunctional (meth)acrylate polymer is 200000 or less, and thus low shear rate dependency and good spin-coatability may be obtained. From this viewpoint, the weight-average molecular weight of the polyfunctional (meth)acrylate polymer is more preferably 190000 or less, still more preferably 180000 or less, yet still more preferably 150000 or less, and particularly preferably 100000 or less.

The functional group equivalent weight of the polyfunctional (meth)acrylate polymer is preferably from 500 to 20000, more preferably from 700 to 10000, and most preferably from 1000 to 7000.

Examples of the aromatic bifunctional (meth)acrylate include 9,9-bis[4-(2-hydroxy $C_1$ to $C_{20}$ alkoxy)phenyl] fluorene di(meth)acrylate, $C_1$ to $C_{20}$ alkoxylated bisphenol A di(meth)acrylate, benzyl di(meth)acrylate, 1,3-bis(2-(meth) acryloyloxy $C_1$ to $C_{20}$ alkyl)benzene, 2,2-bis(4-(meth)acryloxydiethoxyphenyl)propane, and structural isomers thereof. Preferably, a di(meth)acrylate having a condensed ring skeleton such as fluorene, indene, indecene, anthracene, azulene, or triphenylene may be included.

Examples of the alicyclic bifunctional (meth)acrylate include $C_1$ to $C_{20}$ alkoxylated hydrogenated bisphenol A di(meth)acrylate, 1,3-di(meth)acryloyloxyadamantane, tricyclo $C_{10}$ to $C_{20}$ alkane dimethanol di(meth)acrylate, dicyclo $C_5$ to $C_{20}$ di(meth)acrylate, and structural isomers thereof.

Examples of the acyclic bifunctional (meth)acrylate include 1,3-butanediol di(meth)acrylate, 1,4-butanediol di(meth)acrylate, 1,6-hexanediol di(meth)acrylate, 1,9-nonanediol di(meth)acrylate, 1,10-decanediol di(meth)acrylate, neopentyl glycol di(meth)acrylate, neopentyl glycol-modified trimethylolpropane di(meth)acrylate, stearic acid-modified pentaerythritol di(meth)acrylate, tripropylene glycol di(meth)acrylate, and caprolactone-modified hydroxy pivalic acid neopentyl glycol di(meth)acrylate.

The component (A) may contain a tri- or higher functional polyfunctional (meth)acrylate. Examples of the trifunctional (meth)acrylate include isocyanuric acid ethylene oxide-modified tri(meth)acrylate, pentaerythritol tri(meth) acrylate, trimethylolpropane tri(meth)acrylate, and tris[(meth)acryloyloxyethyl]isocyanurate.

Examples of the tetrafunctional or higher (meth)acrylate include ditrimethylolpropane tetra(meth)acrylate, dimethylolpropane tetra(meth)acrylate, pentaerythritol tetra(meth)acrylate, pentaerythritol ethoxy tetra(meth)acrylate, dipentaerythritol penta(meth)acrylate, and dipentaerythritol hexa(meth)acrylate.

As the monofunctional (meth)acrylate that may be contained in the component (A), a monofunctional (meth) acrylate having a molecular weight of 550 or less is preferred, and a monofunctional alkyl (meth)acrylate having an alkyl group is more preferred.

The alkyl group is preferably one or more selected from a linear alkyl group, a branched alkyl group, and an alicyclic alkyl group, more preferably one or more selected from a linear alkyl group and a branched alkyl group. From the viewpoint of improving the compatibility with other components, it is preferable that the component (A) has a long-chain and branched or cyclic alkyl group. For example, it is preferable that the component (A) has a branched alkyl group having from 18 to 40 carbons, more preferably from 18 to 32 carbons, such as an isostearyl group, an isotetracosanyl group (e.g. 2-decyl-1-tetradecanyl group), an isotriacontanyl group (e.g. 2-tetradecyl-1-octadecanyl group), or a cycloalkyl group. The use of such a component having a long chain, a highmolecular weight and a strong character of an aliphatic hydrocarbon (more preferably, enhancement of the aliphatic hydrocarbon nature of the entire system) enables the low volatility, chemical resistance and heat resistance required for the composition for temporary bonding to be improved.

One or more selected from the group consisting of stearyl (meth)acrylate, isostearyl (meth)acrylate, behenyl (meth)acrylate, 2-decyl-1-tetradecanyl (meth)acrylate, 2-dodecyl-1-hexadecanyl (meth)acrylate, and 2-tetradecyl-1-octadecanyl (meth)acrylate are preferred as the component (A). As the component (A), a preferred one is a (meth) acrylate of the following Formula 1:

[Chem. 1]

Formula 1

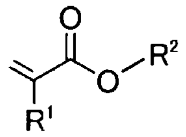

wherein $R^1$ is a hydrogen atom or a methyl group, more preferably a hydrogen atom, and $R^2$ is an alkyl group, and the number of carbons is preferably from 18 to 32. One or more of these (meth)acrylates may be used.

The monofunctional alkyl (meth)acrylate in which $R^2$ is an alkyl group having from 18 to 32 carbons is preferably a (meth)acrylate having a linear or branched alkyl group, such as stearyl (meth)acrylate, isostearyl (meth)acrylate, nonadecyl (meth)acrylate, eicodecyl (meth)acrylate, behenyl (meth)acrylate, 2-decyl-1-tetradecanyl (meth)acrylate, or 2-tetradecyl-1-octadecanyl (meth)acrylate.

In the composition for temporary bonding of the present embodiment, the component (A) includes a (meth) acrylate containing an aromatic ring bonded to a heteroatom.

The (meth)acrylate containing an aromatic ring bonded to a heteroatom may be a monofunctional (meth) acrylate, a bifunctional (meth)acrylate, a tri- or higher functional polyfunctional (meth)acrylate, or a mixture thereof. Preferably, the component (A) may include a combination of a polyfunctional (meth)acrylate and a monofunctional (meth) acrylate, a combination of a polyfunctional (meth)acrylate and a polymerizable polymer, or a combination of a polyfunctional (meth)acrylate, a monofunctional (meth)acrylate, and a polymerizable polymer.

In the (meth)acrylate containing an aromatic ring bonded to a heteroatom, the number of aromatic rings per molecule is not particularly limited, and may be 1, 2, 3, 4, or more, or a mixture of (meth)acrylates having these numbers of aromatic rings. In the (meth)acrylate containing an aromatic ring bonded to a heteroatom, an aromatic ring not bonded to a heteroatom may be present.

The (meth)acrylate containing an aromatic ring bonded to a heteroatom constitutes a part or whole of the equivalent amount of the aromatic ring bonded to the heteroatom contained in 1 g of the composition for temporary bonding of the present invention, as described later.

Examples of the bifunctional (meth)acrylate as the (meth)acrylate containing an aromatic ring bonded to a heteroatom include one or more selected from the group consisting of 9,9-bis[4-(2-hydroxy $C_1$ to $C_{20}$ alkoxy)phenyl] fluorene di(meth)acrylate, $C_1$ to $C_{20}$ alkoxylated bisphenol A di(meth)acrylate, 1,3-bis(2-(meth)acryloyloxy $C_1$ to $C_{20}$ alkyl) benzene, 2,2-bis(4-(meth)acryloxydiethoxyphenyl)propane (including ethoxylated bisphenol A di(meth)acrylate), and structural isomers thereof in the component (A). Preferably, a di(meth)acrylate having a condensed ring skeleton such as fluorene, indene, indecene, anthracene, azulene, or triphenylene may be included.

Examples of the monofunctional (meth)acrylate as the (meth)acrylate containing an aromatic ring bonded to a heteroatom include one or more selected from the group consisting of nonylphenoxypolyethylene glycol (meth)acrylate (including nonylphenol EO-modified (meth)acrylate), phenoxyethyl (meth)acrylate, and structural isomers thereof. Preferably, a (meth)acrylate having a condensed ring skeleton such as fluorene, indene, indecene, anthracene, azulene, or triphenylene may be included.

In a preferred embodiment, the total of (meth)acrylates containing an aromatic ring bonded to a heteroatom in the component (A) may be in a range of 5 to 100% by mass relative to the entire mass of the component (A). Specifically, the total of the (meth)acrylates containing an aromatic ring bonded to a heteroatom in the component (A) may be preferably 5% by mass or more, 10% by mass or more, 15% by mass or more, 20% by mass or more, 25% by mass or more, 30% by mass or more, 40% by mass or more, 50% by mass or more, or 60% by mass or more, relative to the entire mass of the component (A). The total of the (meth)acrylates containing an aromatic ring bonded to a heteroatom in the component (A) is preferably 100 % by mass or less, 90% by mass or less, 85% by mass or less, 80% by mass or less, 75% by mass or less, or 70% by mass or less.

The content of the component (A) is preferably from 60 to 100% by mass, from 70 to 98% by mass, from 80 to 96% by mass, or from 85 to 94% by mass relative to the total amount of the composition for temporary bonding.

In a preferred embodiment, the amount of the non-polymerizable component contained in the composition for temporary bonding of the present embodiment may be 0% by mass or more and less than 10% by mass, or 0% by mass or more and less than 5% by mass. The amount of the non-polymerizable component may be 10% by mass or less or 5% by mass or less. More preferably, the composition for temporary bonding of the present embodiment need not contain the non-polymerizable component except the component (B).

(2. Component (B))

The polymerization initiator, preferably the photo radical polymerization initiator, which is the component (B) contained in the composition for temporary bonding of the present embodiment is a substance that may initiate polymerization of the component (A) upon light irradiation. The photo radical polymerization initiator refers to, for example, a compound in which a molecule is cleaved by irradiation with ultraviolet rays or visible light (e.g. at a wavelength of 350 to 700 nm, preferably 365 to 500 nm, more preferably 385 to 450 nm) and split into two or more radicals. Examples of the photo radical polymerization initiator include bis(2,4,6-trimethylbenzoyl)phenylphosphine oxide, 2,4,6-trimethylbenzoyldiphenylphosphine oxide, bis(η5-2,4-cyclopentadiene-1-yl)-bis(2,6-difluoro-3-(1H-pyrrol-1-yl)-phenyl) titanium, 2-benzyl-2-dimethylamino-1-(4-morpholinophenyl)-butane-1-one, 2-dimethylamino-2-(4-methylbenzyl)-1-(4-morpholine-4-yl-phenyl)-butane-1-one, 1-[4-(phenylthio)phenyl]-1,2-octanedione-2-0-benzoyloxime, and 1-[9-ethyl-6-(2-methylbenzoyl)-9H-carbazole-3-yl]ethanone-1-(0-acetyloxime). The component (B) may include one or more types of these initiators or a combination of two or more types thereof.

In a preferred embodiment of the present invention, the component (B) contained in the composition for temporary bonding may contain an acylphosphine oxide-based compound. Examples of a preferred acylphosphine oxide-based compound include bis(2,4,6-trimethylbenzoyl)phenylphosphine oxide and 2,4,6-trimethylbenzoyldiphenylphosphine oxide. Preferably, the photo radical polymerization initiator has high sensitivity and excellent deep curability because of having photodiscoloration properties, and in addition, an absorption wavelength region for generating radicals extends to a relatively long wavelength region. In the preferred compound described above, the absorption wavelength region is in the range up to a wavelength of about 440 nm, and a difference between the absorption wavelength region and an absorption wavelength region of a UV absorber used in a UV laser peeling step described later is large. That is, the degree of inhibition of UV curing by the UV absorber is small, and radical polymerization may be initiated by light having a longer wavelength. Accordingly, it is possible to obtain an effect that radical polymerization may be efficiently initiated and curing may be carried out at a relatively high speed even in the coexistence with the UV absorber.

In a preferred embodiment, the photo radical polymerization initiator may be selected from absorbance. Specifically, the photo radical polymerization initiator may be selected from one or more kinds of compounds that satisfy any one or more of the following conditions: the absorbance at a wavelength of 365 nm is 0.5 or more; the absorbance at a wavelength of 385 nm is 0.5 or more; and the absorbance at a wavelength of 405 nm is 0.5 or more, when the compound(s) are dissolved at a concentration of 0.1% by mass in a solvent having no maximum absorption in a wavelength region of 300 to 500 nm (e.g. acetonitrile, toluene, etc.). Examples of the compound satisfying such conditions include 1-[9-ethyl-6-(2-methylbenzoyl)-9H-carbazole-3-yl]ethanone-1-(O-acetyloxime) having an absorbance of 0.5 or more at a wavelength of 365 nm; 1-[4-(phenylthio)phenyl]-1,2-octanedione-2-O-benzoyloxime having an absorbance of 0.5 or more at wavelengths of 365 nm and 385 nm; and bis(2,4,6-trimethylbenzoyl)phenylphosphine oxide and 2,4,6-trimethylbenzoyldiphenylphosphine oxide having an absorbance of 0.5 or more at wavelengths of 365 nm, 385 nm, and 405 nm, when each of the compounds is dissolved at a concentration of 0.1 mass% in a solvent: acetonitrile.

From the viewpoint of achieving both curability by the photo radical polymerization initiator and UV laser peeling, bis(η5-2,4-cyclopentadiene-1-yl)-bis(2,6-difluoro-3-(1H-pyrrol-1-yl)-phenyl)titanium having an absorption wavelength region in a range of 400 to 500 nm may also be used as the photo radical polymerization initiator.

The photo radical polymerization initiator (B) is preferably one or more selected from an acylphosphine oxide-based compound, a titanocene-based compound, and an α-aminoalkylphenone-based compound in that the photo radical polymerization initiator has a reaction rate, heat resistance after curing, low outgassing properties, and absorption characteristics in a region different from the wavelength of a UV laser used for UV laser peeling described later and the absorption wavelength region of a UV absorber used for the UV laser peeling. In addition to the above, an oxime ester-based compound may also be selected as a photo radical polymerization initiator for a resin composition for temporary bonding to be used in preventing breaking in the process from the bonding step of the base material to be processed to the support member to the heating step, which is not a layer corresponding to the UV laser peeling step, in the composition for temporary bonding having a structure described later.

Examples of the acylphosphine oxide-based compound include bis(2,4,6-trimethylbenzoyl)phenylphosphine oxide and 2,4,6-trimethylbenzoyldiphenylphosphine oxide. In the two compounds, bis(2,4,6-trimethylbenzoyl)phenylphosphine oxide is particularly preferred.

The titanocene-based compound is, for example, bis(η5-2,4-cyclopentadiene-1-yl)-bis(2,6-difluoro-3-(1H-pyrrol-1-yl)-phenyl)titanium.

Examples of the α-aminoalkylphenone-based compound include 2-benzyl-2-dimethylamino-1-(4-morpholinophenyl)-butane-1-one and 2-dimethylamino-2-(4-methylbenzyl)-1-(4-morpholine-4-yl-phenyl)-butane-1-one.

Examples of the oxime ester-based compound include 1-[4-(phenylthio)phenyl]-1,2-octanedione 2-O-benzoyloxime, and 1-[9-ethyl-6-(2-methylbenzoyl)-9H-carbazole-3-yl]ethanone 1-(O-acetyloxime). Among these compounds, 1-[9-ethyl-6-(2-methylbenzoyl)-9H-carbazole-3-yl]ethanone 1-(O-acetyloxime) is preferred.

In a preferred embodiment of the present invention, the component (B) in the composition for temporary bonding

is one or more selected from bis(2,4,6-trimethylbenzoyl)phenylphosphine oxide, 2,4,6-trimethylbenzoyldiphenylphosphine oxide, and 1-[9-ethyl-6-(2-methylbenzoyl)-9H-carbazole-3-yl]ethanone 1-(O-acetyloxime).

The amount of the photo radical polymerization initiator (B) to be used is preferably from 0.01 to 5 parts by mass, more preferably from 0.01 to 3 parts by mass, still more preferably from 0.1 to 2 parts by mass, and yet still more preferably from 0.1 to 1 parts by mass, relative to a total of 100 parts by mass of the component (A), from the viewpoint of reaction rate, heat resistance after curing, and low outgassing properties. When the component (B) is 0.01 parts by mass or more, sufficient curability is obtained. When the component is 5 parts by mass or less, an effect that low outgassing properties and heat resistance are unlikely to be impaired is obtained.

(3. Component (C))

The ultraviolet absorber (UV absorber) having a polymerizable functional group: the component (C) contained in the composition for temporary bonding of the present embodiment refers to a compound in which molecules cut by irradiation with ultraviolet rays or visible light laser are decomposed and vaporized, and the decomposition and vaporization are generated at an interface between the support member and a cured product of the composition for temporary bonding (hereinafter, also referred to as an agent for temporary bonding), thereby losing the adhesiveness between the cured product of the composition for temporary bonding and the support member that has been maintained until immediately before the UV laser peeling step. The component (C) is a compound having one or more selected from the group consisting of a benzophenone skeleton, a triazole skeleton, a hydroxyphenyl triazine skeleton, and a phenol skeleton (preferably a hindered phenol skeleton). The reason for having these skeletons is to obtain the degree of overlap with the UV laser light wavelength in the UV absorption wavelength region, UV absorption characteristics at the same wavelength, low outgassing properties, and heat resistance. The polymerizable functional group of the component (C) is preferably a (meth)acryloyl group. In order to favorably obtain the effect of the present invention, the component (C) preferably has an absorption peak for light having a wavelength of 350 nm to 385 nm.

As an example of the component (C), one or more selected from the group consisting of 2-[2-hydroxy-5-[2-((meth)acryloyloxy)ethyl]phenyl]-2H-benzotriazole, 2-[1-(2-hydroxy-3,5-di-tert-pentylphenyl)ethyl]-4,6-di-tert-pentylphenyl (meth)acrylate, 2-(2-(meth)acryloyloxy, 5-methyl)phenyl-2H-benzotriazole, 1,1-bis-[2-(meth)acryloyloxy,3-(2H-benzotriazole-2-yl),5-tertiary octyl]methane, and 2,2'-dihydroxy-4,4'-di(meth)acryloyloxybenzophenone are particularly preferred from the viewpoint of compatibility with the resin component, UV absorption characteristics, low outgassing properties, and heat resistance.

The amount of the component (C) is preferably from 0.005 to 15 parts by mass, preferably from 0.01 to 12 parts by mass, more preferably from 0.1 to 10 parts by mass, and still more preferably from 0.5 to 7 parts by mass, relative to a total of 100 parts by mass of the component (A). When the content is 0.01 parts by mass or more, a sufficient UV laser peeling rate is obtained. When the content is 15 parts by mass or less, an effect that low outgassing properties and heat resistance are unlikely to be impaired is obtained.

(4. Composition for Temporary bonding)

In the composition for temporary bonding of the present invention, the equivalent amount of the aromatic ring bonded to the heteroatom contained in 1 g of the composition for temporary bonding is 0.50 mmol or more and 3 mmol or less.

The absorption peak of an aromatic ring generally has an absorption at about 200 nm. In a case where an element adjacent to the aromatic ring is a hetero element such as P, S, or O, the conjugation length is extended, and the absorption edge is also extended to 355 nm. Thus, it is estimated that the energy of the laser light is likely to be absorbed and decomposed. However, the present invention is not restricted by any theory.

From the above viewpoint, it is assumed that the equivalent amount of the aromatic ring bonded to the heteroatom contained in 1 g of the composition for temporary bonding is 0.50 mmol or more in order to enhance the absorption of the energy of the laser light. The equivalent amount of the aromatic ring bonded to the heteroatom contained in 1 g of the composition for temporary bonding is preferably 0.55 mmol or more, more preferably 0.6 mmol or more, still more preferably 0.60 mmol or more, yet still more preferably 0.65 mmol or more, even yet still more preferably 0.7 mmol or more, and even still more preferably 0.70 mmol or more.

However, in a case where the equivalent amount of the aromatic ring bonded to the heteroatom is too high, the support member and the wafer cannot follow the strain due to a difference in linear coefficient of expansion between the support member and the wafer during a heat-treatment, and the support member and the wafer may be broken. From this viewpoint, the equivalent amount of the aromatic ring bonded to the heteroatom contained in 1 g of the composition for temporary bonding is set to 3 mmol or less. The equivalent amount of the aromatic ring bonded to the heteroatom contained in 1 g of the composition for temporary bonding is preferably 3.0 mmol or less, preferably 2.8 mmol or less, more preferably 2.5 mmol or less, still more preferably 2 mmol or less, yet still more preferably 2.0 mmol or less, even yet still

more preferably 1.9 mmol or less, even still more preferably 1.8 mmol or less, even still more further preferably 1.7 mmol or less, and even yet still more further preferably 1.6 mmol or less.

The equivalent amount of the aromatic ring bonded to the heteroatom is not necessarily derived from the component (A), and may be derived from the component (B) or the component (C).

When the equivalent amount of the aromatic ring bonded to the heteroatom contained in 1 g of the composition for temporary bonding is 0.50 mmol or more and 3 mmol or less, the adhesive layer may be decomposed by a low laser output. Thus, it is possible to perform peeling in a state where heat generation is suppressed. In addition, the decomposition of the adhesive layer is promoted, and thus, when the remaining adhesive layer is washed after peeling, it is possible to expect an advantage of easy washing.

(5. Adhesive for Temporary bonding)

The composition for temporary bonding of the present invention may be used as an adhesive for temporary bonding, particularly an adhesive for temporary bonding for producing an electronic device such as a thin wafer. The adhesive for temporary bonding is preferably composed only of the composition for temporary bonding of the present invention.

(6. Method for Producing Thin Wafer)

In another embodiment of the present invention, there is also provided a method for producing a thin wafer using the adhesive for temporary bonding of the present invention. The method includes: bonding a base material of a thin wafer to an optically transparent support member with the adhesive for temporary bonding interposed therebetween; photo-curing the adhesive for temporary bonding from a side of the support member to form an adhesive layer and causing the base material to adhere to the support member; processing the base material to form a thin wafer; and emitting light having a wavelength of 350 nm to 385 nm from the side of the support member to decompose the adhesive layer, and peeling the thin wafer from the support member.

The method for bonding a base material of a thin wafer to an optically transparent support member is not particularly limited. Typically, the adhesive for temporary bonding is applied to the optically transparent support member, and then the base material is bonded to the surface to which the adhesive for temporary bonding has been applied.

As a method for applying the adhesive for temporary bonding, known application methods such as spin coating, screen printing, and various coaters may be used. The viscosity of the composition for temporary bonding of the present embodiment at 23°C (under atmospheric pressure) is preferably 500 mPa · s or more, more preferably 1000 mPa · s or more, from the viewpoint of coating properties and workability. The viscosity of the composition for temporary bonding of the present embodiment at 23°C (under atmospheric pressure) is preferably 15000 mPa · s or less, more preferably 10000 mPa · s or less, and still more preferably 5000 mPa · s or less, from the viewpoint of coating properties and workability. When the viscosity is 500 mPa · s or more, coating properties, particularly coating properties by spin coating is excellent. When the viscosity is 15000 mPa · s or less, the workability is excellent. The viscosity may be measured with a known viscometer.

The spin coating is, for example, a method in which a liquid composition is dropped on a support member and the support member is rotated at a predetermined rotation speed to apply the composition to the surface of the support member. The spin coating enables a high-quality coating film to be efficiently produced.

In causing the base material to be processed to adhere to the support member, the base material to be processed and the support member are cured by irradiation with light. The wavelength of light may be appropriately selected according to the type of the photo radical polymerization initiator (B), and is typically, for example, from 350 nm to 700 nm. Particularly, it is preferable to perform irradiation with visible light or ultraviolet rays (wavelength or center wavelength: 365 to 405 nm) such that the energy amount is from 1 to 20000 $mJ/cm^2$. When the energy amount is 1 $mJ/cm^2$ or more, sufficient adhesiveness is obtained. When the energy amount is 20000 $mJ/cm^2$ or less, the productivity is excellent, a decomposition product from the photo radical polymerization initiator is unlikely to be generated, and the generation of outgas is suppressed. The energy amount is preferably from 1000 to 10000 $mJ/cm^2$ from the viewpoint of productivity, adhesiveness, low outgassing properties, and easy peeling properties. It is to be noted that the wavelength of light herein is preferably selected from a range different from the wavelength of laser light for decomposing the adhesive layer described later.

Although the base material to be processed and the support member are not particularly limited, at least one of the base materials is preferably a transparent base material that transmits light. Examples of the transparent base material include inorganic base materials such as crystal, glass, quartz, calcium fluoride, and magnesium fluoride, and organic base materials such as plastic. Among them, inorganic base materials are preferred from the viewpoint of having versatility and obtaining a large effect. Among the inorganic base materials, one or more selected from glass and quartz are preferred.

After causing the base material to be processed to adhere to the support member, the base material is processed to form a thin wafer. The contents of processing typically include thinning processing by grinding and polishing, high temperature processing, and the like.

After the thin wafer is formed, light having a wavelength of 350 nm to 385 nm is emitted from the side of the support member to decompose the adhesive layer. For example, the adhesive layer may be decomposed by irradiating the entire surface with a UV laser having a wavelength of 350 nm to 385 nm so as to scan the entire surface. As described above, the aromatic ring bonded to the heteroatom is likely to absorb the energy of the laser light having a wavelength of about 355 nm, the effect of improving the energy absorption becomes more remarkable by setting the wavelength of the laser light within a range of 350 nm to 385 nm.

## Examples

Hereinafter, the present invention will be described in more detail based on Examples and Comparative Examples, but the present invention is not limited thereto.

Unless otherwise specified, the experiment was performed at 23°C and a humidity of 50%. Compositions for temporary bonding having the composition (unit: part(s) by mass) shown in the following table were prepared and evaluated. As respective components, the following compounds were selected.

(Composition)

As the component (A), components described below were used.

APB-001 (polyfunctional acrylate polymer, "APB-001" manufactured by Negami Chemical Industrial Co., Ltd., weight-average molecular weight: 72,000, functional group equivalent weight: 1400)
A-BPEF-2: 9,9-Bis[4-(2-hydroxyethoxy)phenyl]fluorene diacrylate ("NK Ester A-BPEF-2" manufactured by SHIN-NAKAMURA CHEMICAL Co., Ltd.)
ABE-300: Ethoxylated bisphenol A diacrylate ("NK Ester ABE-300" manufactured by SHIN-NAKAMURA CHEMICAL Co., Ltd., R=$-CH_2CH_2O-$, m + n ≈ 3 in the following structural formula)
A-BPE-2: Ethoxylated bisphenol A diacrylate ("NK Ester A-BPE-2" manufactured by SHIN-NAKAMURA CHEMICAL Co., Ltd., R=$-CH_2CH_2O-$, m = n = 1 in the following structural formula)

[Chem. 2]

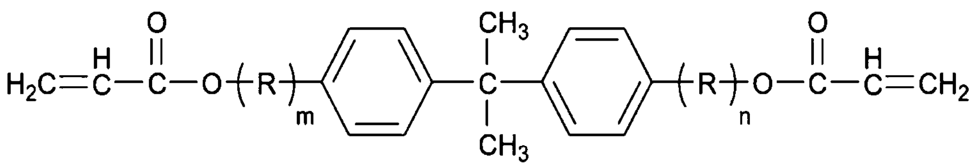

HBPE-4: EO-modified hydrogenated bisphenol A diacrylate ("HBPE-4 " manufactured by DKS Co. Ltd., m + n ≈ 4)
A-DOD-N: 1,10-Decanediol diacrylate ("A-DOD-N" manufactured by SHIN-NAKAMURA CHEMICAL Co., Ltd.)
HX-220: caprolactone-modified hydroxy pivalic acid neopentyl glycol diacrylate ("KAYARAD HX -220" manufactured by Nippon Kayaku Co., Ltd., m + n ≈ 2)
HX-620: caprolactone-modified hydroxy pivalic acid neopentyl glycol diacrylate ("KAYARAD HX -620" manufactured by Nippon Kayaku Co., Ltd., m + n ≈ 4)
A-TMPT: Trimethylolpropane triacrylate ("A-TMPT" manufactured by SHIN-NAKAMURA CHEMICAL Co., Ltd.)
RC110C (Both-terminal acrylate polymer, "XMAP RC110C" manufactured by KANEKA CORPORATION, weight-average molecular weight 12,000, functional group equivalent weight 6,000)
M-113: Nonylphenol polyethoxylate acrylate ("ARONIX M-113" manufactured by TOAGOSEI CO., LTD., n ≈ 4)
ISTA: Isostearyl acrylate ("ISTA" manufactured by OSAKA ORGANIC CHEMICAL INDUSTRY LTD.)
Bis(2,4,6-trimethylbenzoyl)phenylphosphine oxide ("Irgacure 819" manufactured by BASF) was used as the component (B).

As the component (C), the following were used.

RUVA-93: 2-[2-Hydroxy-5-[2-(methacryloyloxy)ethyl]phenyl]-2H-benzotriazole ("RUVA -93" manufactured by Otsuka Chemical Co., Ltd.)

P-66: 2,2'-Dihydroxy-4,4'-diacryloyloxybenzophenone ("DAINSORB P-66" manufactured by Daiwa Fine Chemicals Co., Ltd.)

(Preparation of Liquid Sample)

As shown in Tables 1-1 and 1-2, for each of Comparative Examples and Examples, materials were heated and mixed at 60°C to prepare compositions for temporary bonding as uniform liquid compositions. In addition, Tables 1-1 and 1-2 show the presence or absence of an aromatic ring bonded to a heteroatom for each of the components, and the equivalent amount of the aromatic ring bonded to the heteroatom calculated from the amount of each of the components in each of Examples is shown in parentheses. The calculation formula is as follows:

Equivalent amount (mmol) of aromatic ring bonded to heteroatom = (number of parts of the compound blended/molecular weight (g/mol) of the compound) × (number of aromatic rings bonded to heteroatom contained in one molecule of the compound) × 1000

(Preparation of Bonding Sample)

A 4-inch silicon wafer (10 cm in diameter × 0.47 mm in thickness) and a 4-inch glass support member (10 cm in diameter × 0.7 mm in thickness) were bonded to each other using the prepared liquid composition. In the bonding, the thickness of the liquid composition was adjusted to 50 μm. After bonding, the resultant bonded product was cured with black light having a wavelength of 365 nm under the conditions of an illuminance of 100 $mW/cm^2$, an irradiation time of 50 seconds, and an integrated light amount of 5000 $mJ/cm^2$, and then the cured product was placed on a hot plate heated to 180°C for performing a heat-treatment for 30 minutes, thereby preparing a test piece for adhesiveness evaluation. The liquid composition was applied to the entire surface of the bonding surface.

(Evaluation of Laser Peeling Properties)

An area of a perfect circle having a diameter of 110 mm fixed in the center of the resulting 4-inch test piece was irradiated with a UV laser having a wavelength of 355 nm so as to scan the entire surface of the test piece from the side of the glass support member.

A razor blade was brought into contact with a circumferential portion of the test piece after laser irradiation to remove a protruding portion from the circumferential portion. Three suckers having a diameter of 30 mm were attached to the top of the glass support member of the test piece in a state where the silicon wafer was placed and fixed on a porous vacuum chuck with the silicon wafer facing down. A load measuring module was attached to the suckers, and a peeling load on the glass support member was measured by a method of lifting the suckers vertically upward. As a parameter for evaluating peeling properties, a laser output (W) required for peeling the glass from the wafer up to a load of 10 N was measured, and the measurement results were shown in Tables 1-1 and 1-2. The smaller the value is, the more likely the glass is peeled from the wafer.

[Table 1-1]

| | | Presence or absence of aromatic ring bonded to heteroatom | Example 1 | Example 2 | Example 3 | Example 4 | Example 5 | Example 6 | Example 7 |
|---|---|---|---|---|---|---|---|---|---|
| (A) | APB-001 | Absence | 15 | - | - | - | 15 | - | - |
| | A-BPEF-2 | Presence | 10 (36.59 mmol) | 10 (36.59 mmol) | 2.5(9.15 mmol) | - | 10 (36.59 mmol) | 10 (36.59 mmol) | 15 (54.89 mmol) |
| | ABE-300 | Presence | | | 25 (106.71 mmol) | 25 (106.71 mmol) | | | |
| | A-BPE-2 | Presence | | 15 (70.67 mmol) | 2.5 (11.78 mmol) | - | | 15 (70.67 mmol) | 20 (94.23 mmol) |
| | HBPE-4 | Absence | 25 | | - | 15 | 25 | | |
| | A-DOD-N | Absence | 10 | | - | 5 | 10 | | |
| | HX-220 | Absence | - | 7.5 | - | 5 | - | 7.5 | 5 |
| | HX-620 | Absence | - | | - | 5 | - | | |
| | A-TMPT | Absence | | 7.5 | 5 | - | | 7.5 | 5 |
| | RC110C | Absence | | 30 | 35 | 30 | | 30 | 25 |
| | M-113 | Presence | 10 (18.50 mmol) | 10 (18.50 mmol) | 10 (18.50 mmol) | - | 10 (18.50 mmol) | 10 (18.50 mmol) | 10 (18.50 mmol) |
| | ISTA | Absence | 30 | 20 | 20 | 15 | 30 | 20 | 20 |
| (B) | Irgacure 819 | Presence | 1.0 (2.39 mmol) | 1.0 (2.39 mmol) | 1.0 (2.39 mmol) | 1.0 (2.39 mmol) | 1.5 (3.59 mmol) | 1.0 (2.39 mmol) | 1.0 (2.39 mmol) |
| (C) | RUVA-93 | Presence | 3.5 (21.65 mmol) | 3.5 (21.65 mmol) | 3.5 (21.65 mmol) | 3.5 (21.65 mmol) | 3.5 (21.65 mmol) | 3.5 (21.65 mmol) | 3.5 (21.65 mmol) |
| | P-66 | Presence | 6 (27.12 mmol) | 6 (27.12 mmol) | 6 (27.12 mmol) | 6 (27.12 mmol) | 5.5 (27.12 mmol) | 6 (27.12 mmol) | 6 (27.12 mmol) |
| Equivalent amount of aromatic ring bonded to heteroatom contained in 1 g of composition for temporary bonding (mmol) | | | 0.95 | 1.6 | 1.79 | 1.43 | 0.97 | 1.6 | 1.98 |
| Evaluation results | Laser peeling properties (W) | | 5.5 | 5 | 5.5 | 5.5 | 5.5 | 5 | 4.5 |

The unit of the amount used is parts by mass.

[Table 1-2]

| | | Presence or absence of aromatic ring bonded to heteroatom | Example 8 | Example 9 | Example 10 | Example 11 | Example 12 | Comparative Example 1 | Comparative Example 2 |
|---|---|---|---|---|---|---|---|---|---|
| (A) | APB-001 | Absence | - | - | - | - | 15 | | |
| | A-BPEF-2 | Presence | 20 (73.18 mmol) | 25 (91.48 mmol) | 30 (109.78 mmol) | 10 (36.59 mmol) | 5 (18.30 mmol) | | 50 (183.0 mmol) |
| | ABE-300 | Presence | | | | | | | |
| | A-BPE-2 | Presence | 20 (94.23 mmol) | 25 (117.79 mmol) | 30 (141.35 mmol) | 15 (70.67 mmol) | | | 50 (235.6 mmol) |
| | HBPE-4<br>A-DOD-N | Absence<br>Absence | | | | | 25<br>20 | | |
| | HX-220 | Absence | 5 | 5 | 5 | 7.5 | | 20 | |
| | HX-620<br>A-TMPT | Absence<br>Absence | 5 | 5 | 5 | 7.5 | | 20 | |
| | RC110C | Absence | 20 | 15 | 10 | 30 | | 30 | |
| | M-113 | Presence | 10 (18.50 mmol) | 10 (18.50 mmol) | 10 (18.50 mmol) | 10 (18.50 mmol) | 5 (9.25 mmol) | | |
| | ISTA | Absence | 20 | 15 | 10 | 20 | 30 | 30 | |
| (B) | Irgacure 819 | Presence | 1.0 (2.39 mmol) | 1.0 (2.39 mmol) | 1.0 (2.39 mmol) | 1.0 (2.39 mmol) | 1.0 (2.39 mmol) | 1.0 (2.39 mmol) | 1.0 (2.39 mmol) |
| (C) | RUVA-93 | Presence | 3.5 (21.65 mmol) | 3.5 (21.65 mmol) | 3.5 (21.65 mmol) | 3.5 (21.65 mmol) | 3.5 (21.65 mmol) | 3.5 (21.65 mmol) | 3.5 (21.65 mmol) |
| | P-66 | Presence | 6 (27.12 mmol) | 6 (27.12 mmol) | 6 (27.12 mmol) | 6 (27.12 mmol) | 6 (27.12 mmol) | 6 (27.12 mmol) | 6 (27.12 mmol) |
| Equivalent amount of aromatic ring bonded to heteroatom contained in 1 g of composition for temporary bonding (mmol) | | | 2.15 | 2.52 | 2.9 | 1.6 | 0.71 | 0.46 | 4.25 |
| Evaluation results | Laser peeling properties (W) | | 4.5 | 4 | 4.5 | 5 | 5.5 | 6 | × |

The unit of the amount used is parts by mass.
× indicates that the agent for temporary bonding was broken.

The results of Tables 1-1 and 1-2 showed that in the composition for temporary bonding of the present invention, the laser output required for peeling the glass from the wafer was low and peeling properties were high. This makes it possible to perform peeling in a state where heat generation is suppressed.

Meanwhile, in Comparative Example 1 in which the equivalent amount of the aromatic ring bonded to the heteroatom is below the lower limit of the range of the present invention, it is found that the laser output required for peeling the glass from the wafer is high and the peeling properties are poor. In Comparative Example 2, the agent for temporary bonding was broken during the heat-treatment of the test piece, and could not be evaluated.

## Claims

1. A composition for temporary bonding comprising the following (A) to (C):

   (A) a polymerizable component comprising a (meth)acrylate comprising an aromatic ring bonded to a heteroatom;
   (B) a photo radical polymerization initiator; and
   (C) an ultraviolet absorber having a polymerizable functional group,

   wherein an equivalent amount of the aromatic ring bonded to the heteroatom in 1 g of the composition for temporary bonding is 0.50 mmol or more and 3 mmol or less.

2. The composition for temporary bonding according to claim 1, wherein the component (A) comprises one or more selected from the group consisting of 9,9-bis[4-(2-hydroxy $C_1$ to $C_{20}$ alkoxy)phenyl]fluorene di(meth)acrylate, $C_1$ to $C_{20}$ alkoxylated bisphenol A di(meth)acrylate, 1,3-bis(2-(meth)acryloyloxy $C_1$ to $C_{20}$ alkyl)benzene, 2,2-bis(4-(meth)acryloxydiethoxyphenyl)propane, and structural isomers thereof.

3. The composition for temporary bonding according to claim 1, wherein the component (A) comprises one or more selected from the group consisting of nonylphenoxypolyethylene glycol (meth)acrylate, phenoxyethyl (meth)acrylate, and structural isomers thereof.

4. The composition for temporary bonding according to claim 1 or 2, wherein the component (B) is one or more selected from bis(2,4,6-trimethylbenzoyl)phenylphosphine oxide and 1-[9-ethyl-6-(2-methylbenzoyl)-9H-carbazole-3-yl]ethanone 1-(O-acetyloxime).

5. The composition for temporary bonding according to claim 1 or 2, wherein the component (C) has one or more selected from the group consisting of a benzophenone skeleton, a triazole skeleton, a hydroxyphenyl triazine skeleton, and a phenol skeleton, and has a polymerizable functional group.

6. The composition for temporary bonding according to claim 1 or 2, wherein a content of the component (B) is from 0.01 to 5 parts by mass and a content of the component (C) is from 0.005 to 15 parts by mass, relative to a total of 100 parts by mass of the component (A).

7. An adhesive for temporary bonding comprising the composition for temporary bonding according to claim 1 or 2.

8. A method for producing a thin wafer using the adhesive for temporary bonding according to claim 7, the method comprising the steps of:

   bonding a base material of a thin wafer to an optically transparent support member with the adhesive for temporary bonding interposed therebetween;
   photo-curing the adhesive for temporary bonding from a side of the support member to form an adhesive layer and causing the base material to adhere to the support member;
   processing the base material to form a thin wafer; and
   emitting light having a wavelength of 350 nm to 385 nm from the side of the support member to decompose the adhesive layer, and peeling the thin wafer from the support member.

9. A composition comprising the following (A) to (C):

(A) a polymerizable component comprising a (meth)acrylate comprising an aromatic ring bonded to a heteroatom;
(B) a polymerization initiator; and
(C) an ultraviolet absorber having a polymerizable functional group,

wherein an equivalent amount of the aromatic ring bonded to the heteroatom in 1 g of the composition is 0.50 mmol or more and 3 mmol or less.

## INTERNATIONAL SEARCH REPORT

International application No.
**PCT/JP2024/001583**

### A. CLASSIFICATION OF SUBJECT MATTER

***C09J 4/02***(2006.01)i; ***C08F 220/10***(2006.01)i; ***C08F 220/26***(2006.01)i; ***H01L 21/02***(2006.01)i
FI: C09J4/02; C08F220/26; H01L21/02 B; H01L21/02 C; C08F220/10

According to International Patent Classification (IPC) or to both national classification and IPC

### B. FIELDS SEARCHED

Minimum documentation searched (classification system followed by classification symbols)

C09J1/00-201/10; C08F220/10; C08F220/26; H01L21/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| A | WO 2022/230874 A1 (DENKA CO., LTD.) 03 November 2022 (2022-11-03)<br>claims 1-2, paragraphs [0064], [0083]-[0093], [0151], [0166], table 1a, examples | 1-9 |
| A | JP 2023-8789 A (NIPPON STEEL CHEMICAL & MATERIAL CO., LTD.) 19 January 2023 (2023-01-19)<br>claim 1, paragraph [0258], table 1, example 1 | 1-9 |
| A | KR 10-2015-0024708 A (SNU R&DB FOUNDATION) 09 March 2015 (2015-03-09)<br>claims 1-2, 15, paragraphs [0001], [0117]-[0122], [0136], example 1 | 1-9 |
| A | JP 6-177094 A (MITSUI TOATSU CHEM., INC.) 24 June 1994 (1994-06-24)<br>claim 1, paragraph [0033], example 1 | 1-9 |
| P, X | WO 2023/181635 A1 (DENKA CO., LTD.) 28 September 2023 (2023-09-28)<br>claims 1-10, paragraphs [0078]-[0086], table 1, examples a1-a7 | 1-9 |

☐ Further documents are listed in the continuation of Box C.   ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **07 March 2024** | **19 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/001583**

| Patent document cited in search report | Publication date (day/month/year) | Patent family member(s) | Publication date (day/month/year) |
|---|---|---|---|
| WO 2022/230874 A1 | 03 November 2022 | CN 117242146 A | |
| | | KR 10-2023-0156137 A | |
| | | TW 202248231 A | |
| JP 2023-8789 A | 19 January 2023 | CN 115141552 A | |
| | | KR 10-2022-0136129 A | |
| | | TW 202302788 A | |
| KR 10-2015-0024708 A | 09 March 2015 | (Family: none) | |
| JP 6-177094 A | 24 June 1994 | (Family: none) | |
| WO 2023/181635 A1 | 28 September 2023 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2021235406 A